# EUROPEAN PATENT APPLICATION

(11) **EP 0 884 781 A2**
(43) Date of publication of application: **16.12.1998**
(21) Application number: 98110366.6
(22) Date of filing: 05.06.1998
(51) Int. Cl.: H01L 25/07, H01L 25/16

(54) **Power semiconductor module**

(30) Priority: 12.06.1997 JP 154746/97
(71) Applicant: Hitachi, Ltd., Chiyoda-ku, Tokyo 101-8010 (JP)
(72) Inventor: Sonobe, Yukio, Hitachiohta-shi, Ibaraki 313-0022 (JP); Tanba, Akihiro, Hitachi-shi, Ibaraki 319-1222 (JP); Yamada, Kazuji, Hitachi-shi, Ibaraki 316-0025 (JP); Saito, Ryuichi, Hitachi-shi, Ibaraki 319-1225 (JP); Sasaki, Masataka, Narashino-shi, Chiba 275-0002 (JP); Shigemura, Tatsuya, Hitachinaka-shi, Ibaraki 312-0014 (JP); Suzuki, Kazuhiro, Mito-shi, Ibaraki 310-0011 (JP); Sekine, Shigeki, Hitachi-shi, Ibaraki 316-0006 (JP)
(74) Representative: Strehl Schübel-Hopf & Partner

(57) **Abstract**

A power semiconductor module comprises a metal base, plural wiring substrates provided on said the base, a first wiring substrate of the wiring substrates having a power circuit portion including a power semiconductor device, and a substrate containing portions having a resin portion in which one of the wiring substrstes is contained. The one of the wiring substrates is positioned in self-alignment on the metal substrate on the basis of an inner wall of the resin portion of the substrate containing portion.

## Description

### BACKGROUND OF THE INVENTION

The present invention relates to a structure of a power module (hereinafter, referred to as a "PM") and a structure of an intelligent power module (hereinafter, referred to as an "IPM"), represented by an IGBT (Insulated Gate Bipolar Transistor).

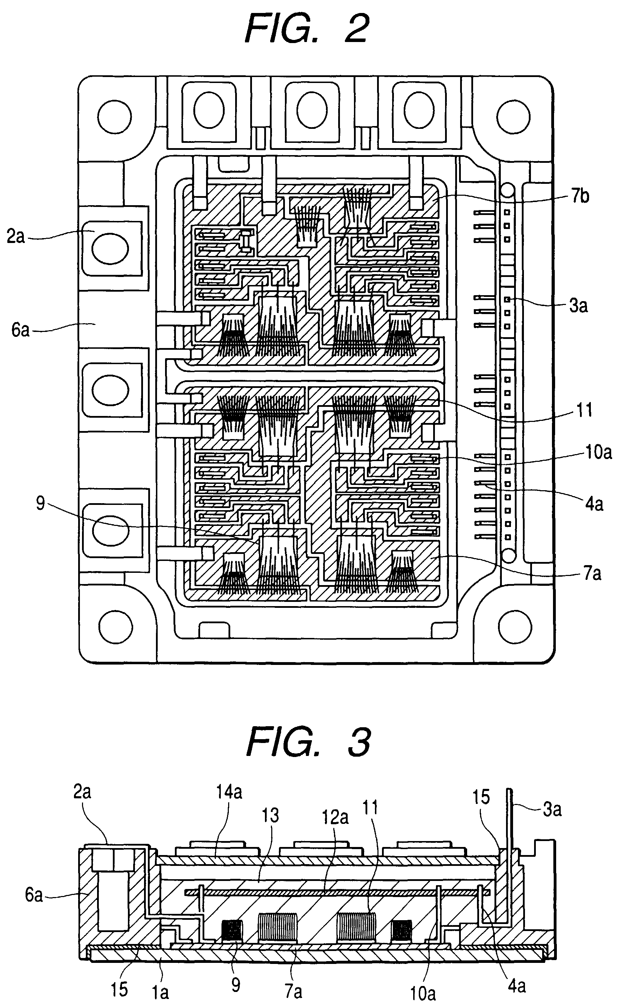

Figs. 2 and 3 are a plan view and a sectional view showing one example of a prior art IPM structure. A case 6a of the prior art IPM has a so-called case block structure with terminals sealed with resin. That is, the case 6a is formed by molding a resin in a die with main terminals 2a and control terminals 3a previously inserted in the die. Ceramic substrates 7a and 7b are provided to electrically insulate power semiconductor devices 9 from a metal base 1a for mounting the module, and has circuit patterns which are formed on conductors on the ceramic substrates 7a and 7b and which are wired using metal wires 11 by wire bonding, to thus constitute a power circuit portion. The ceramic substrates 7a and 7b thus wired by wire bonding are soldered with the metal base 1a to radiate heat generated from the power semiconductor devices 9 through fins (not shown) for mounting the metal base 1a on the module. The case 6a is joined to the metal base 1a with adhesive 15, to form a module housing. The main terminals 2a insert-molded with resin are soldered with the conductor patterns formed on the ceramic substrates 7a and 7b, to be thus electrically connected to the power circuit portion. A circuit substrate 12a which mounts a control circuit for controlling the power circuit is soldered with the conductor circuit patterns formed on central portions on the right and left sides of the ceramic substrates 7a and 7b constituting the power circuit through L-shaped pin terminals 10a, to be thus electrically connected to the power circuit portion. The control terminals 3a insert-molded with resin are raised at right angles inside the case 6a to form control terminals 4a. The control terminals 4a are soldered, together with the pin terminals 10a, with the circuit substrate 12a for mounting the control circuit, to constitute input/output control terminals to be electrically connected to the exterior of the module.

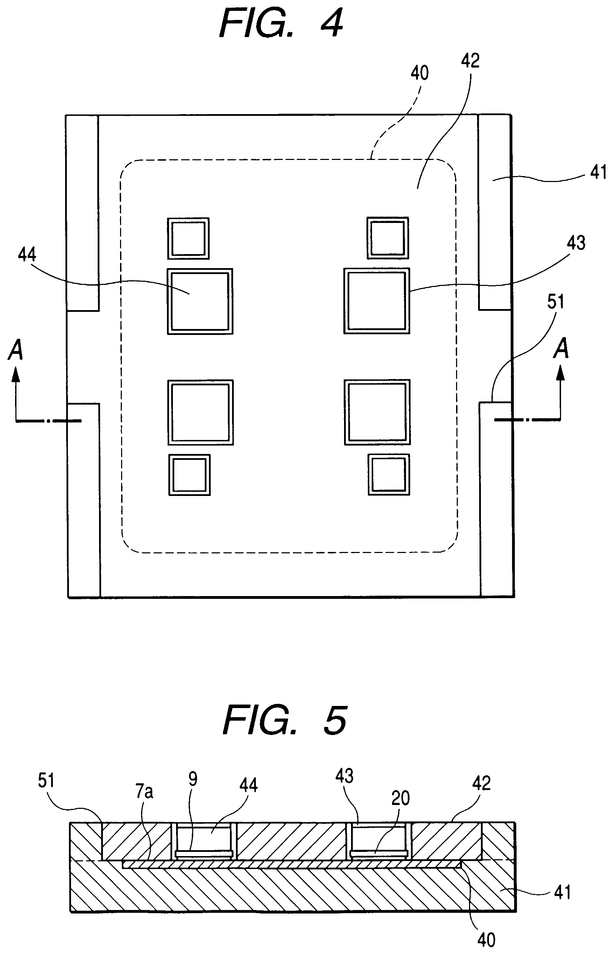

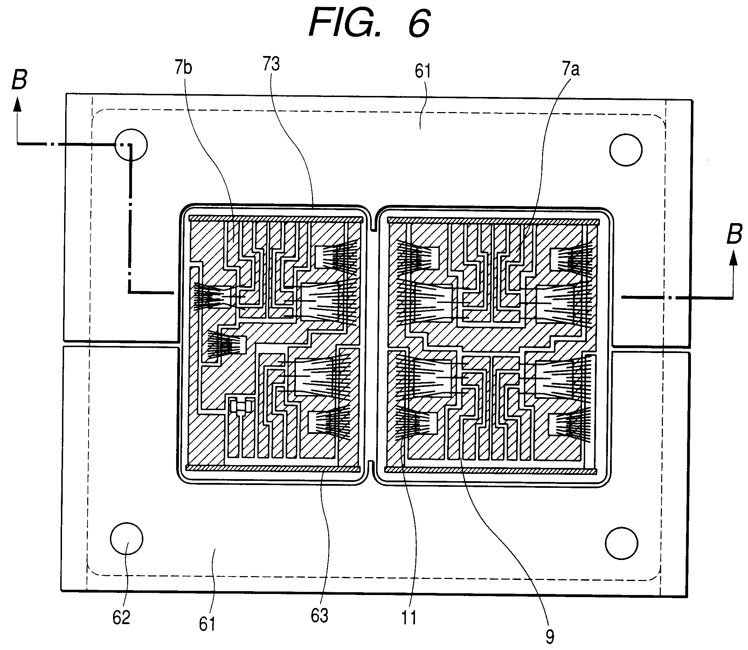

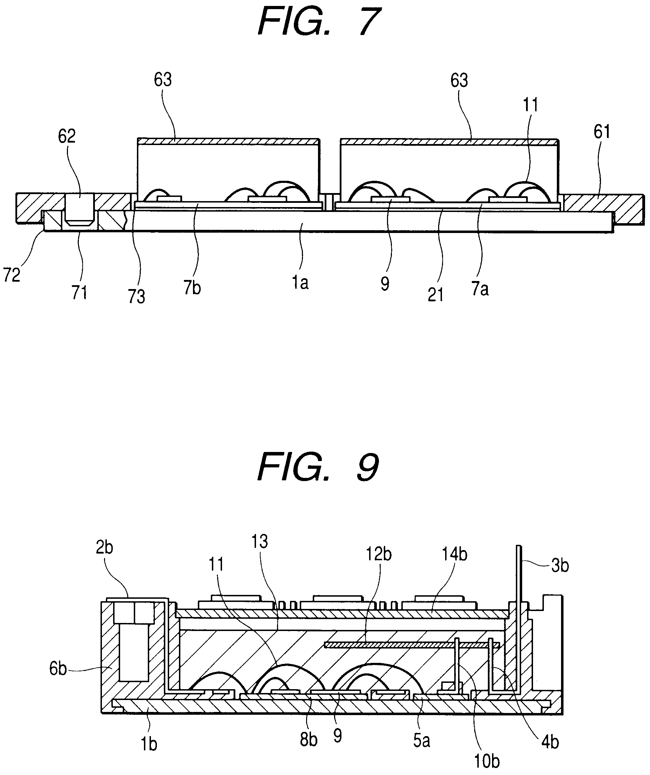

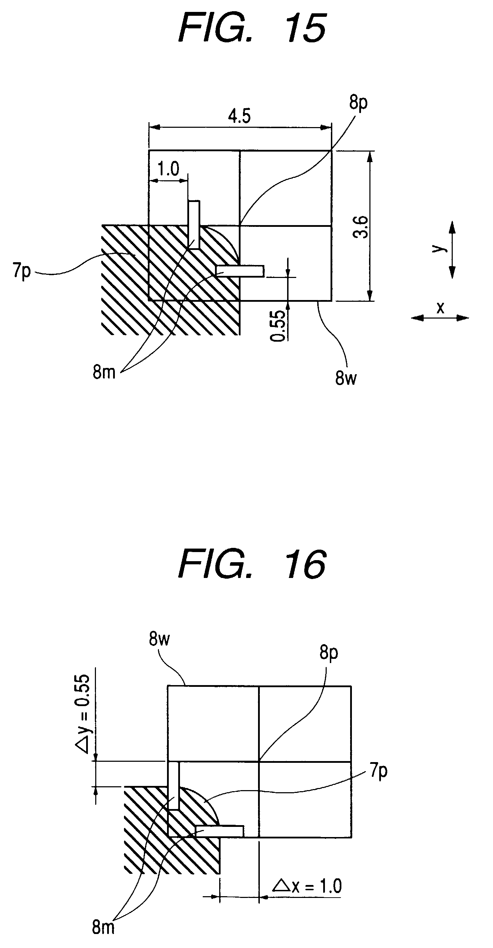

Fig. 4 is a plan view of a jig assembly showing a prior art soldering step 1 for soldering power semiconductor devices with a ceramic substrate; Fig. 5 is a sectional view taken on line A-A of Fig. 4; Fig. 6 is a plan view of a jig assembly showing a soldering step 2 for soldering the ceramic substrate wired by wire bonding with a base substrate; Fig. 7 is a sectional view taken on line B-B of Fig. 6; and Fig. 15 is a typical view showing a reference coordinate for wire bonding and a recognition range thereof.

The IPM is assembled in accordance with the following procedure. Referring to Figs. 4 and 5, the ceramic substrate 7a is set in a groove 40 of a lower jig 41 made from carbon and an upper jig 42 is inserted in a fitting portion 51 of the lower jig 41, to thus fix the ceramic substrate 7a between the upper and lower jigs 42 and 41. A solder sheet 20 and the power semiconductor device 9 are set in each square hole provided in the upper jig 42, followed by placing of a weight 44, and the power semiconductor device 9 is soldered with the ceramic substrate 7a by reflow of the solder sheet 20. The positioning between the ceramic substrate 7a and the power semiconductor device 9 is performed by the groove 40 formed in the lower jig 41, an outer peripheral end surface of the ceramic substrate 7a, and the square hole formed in the upper jig 42 fitted in the lower jig 41. The same procedure is repeated for the ceramic substrate 7b, thus completing the soldering step 1.

With respect to the ceramic substrates 7a and 7b thus processed at the soldering step 1, the power semiconductor devices 9 are wired to conductor patterns of the ceramic substrates 7a and 7b using the metal wires 11 by wire bonding, to fabricate a power circuit portion. At this time, a wire bonding position is set with both a corner 7p of a conductor pattern of the substrate shown in Fig. 15 and a bonding pad of the power semiconductor device 9 taken as coordinate recognition reference points for wire bonding. The ceramic substrates 7a and 7b already wired by wire bonding are assembled to the metal base 1a by inserting pins 62 provided on a carbon made jig 61 divided into two parts into module mounting holes 71 formed in the metal base 1a, and positioning the ceramic substrate 7a and 7b, on which the power semiconductor devices 9 are mounted, with an inner end surface 73 of the jig 61 taken as a guide on the basis of an end surface 72 of the metal base 1a. To be more specific, one of the two-divided parts of the jig 61 is set in the metal base 1a; a solder sheet 21 is placed on the inner side of the jig 61; and the ceramic substrates 7a and 7b already wired by wire bonding are inserted in the jig 61 using the inner end surface 73 as the guide. The other of the two-divided parts of the jig 61 is inserted in the metal base 1a, to prevent the final positioning of the ceramic substrates 7a and 7b and also prevent deviation thereof. Cover weights 63 are placed on the ceramic substrates 7a and 7b, and the ceramic substrates 7a and 7b are soldered with the metal base 1a by reflow of the solder sheet 21, thus completing the soldering step 2.

The metal base 1a on which the power circuit portion is mounted by the above works is bonded by means of thermosetting adhesive 15 on the above case 6a integrated with the terminals formed by insert-molding of resin, to thus obtain a module housing. The L-shaped pin terminals 10a for electrically connecting the control circuit substrate 12a to the power circuit portion formed on the ceramic substrates 7a and 7b are soldered, together with the main terminals 2a provided inside the case 6a by insert-molding of resin, with the conductor circuit patterns of the substrates 7a and 7b, thus completing the soldering step 3. With respect to the circuit substrate 12a on which the control circuit is mounted, the pin terminals 10a and the control terminals 4a raised at right angles inside the case are inserted in through-holes formed in the circuit substrate 12a, and are soldered thereto at the soldering step 4. Then, silicon gel 13 is poured in the package thus prepared, being hardened, and a lid 14a is fixedly bonded on the case 6a with the adhesive 15, thus completing the IPM.

### [Problem to be Solved by the Invention]

As described above, the prior art power semiconductor module requires a number of the soldering steps and a number of the bonding steps using thermosetting adhesive, with a result that portions previously joined by soldering and portions previously joined using the metal wires by wire bonding are repeatedly exposed to high temperatures and are thereby degraded, to be thus reduced in reliability thereof. Further, since the power semiconductor devices 9, ceramic substrates 7a and 7b, and pin terminals 10a are all positioned by the jigs upon soldering works, there occur positional deviations therebetween due to errors accumulated for each soldering step. In particular, each of the ceramic substrates 7a and 7b has a large work dimension tolerance depending on a material characteristic thereof (in this embodiment, the tolerance of each of the ceramic substrates 7a and 7b is ± 0.5 mm at maximum), and in this embodiment, if assembly is performed using the positioning jigs in consideration of the maximum dimension tolerance of each of the ceramic substrates 7a and 7b, there occur the following positional deviations.

The soldering step 1 shown in Figs. 4 and 5 requires the following tolerances and clearances: a work dimension tolerance of the groove 40 provided in the jig 41 (±0.1 mm); a work dimension tolerance of the square hole 43 provided in the jig 42 (±0.05 mm); a work dimension tolerance of each of the ceramic substrates 7a and 7b (± 0.5 mm); a clearance for setting the ceramic substrates 7a and 7b in the groove 40 of the jig 41 (0.1 mm); a clearance for setting the power semiconductor device 9 in the square hole 43 of the jig 42 (0.05 mm); and a clearance in the fitting portion between the lower jig 41 and the upper jig 42 (0.1 mm), and accordingly, thee occurs a positional deviation of 0.9 mm at maximum between each of the ceramic substrates 7a and 7b and the power semiconductor device 9. As a result, there occurs a deviation between a predetermined reference coordinate recognition position for wiring bonding and a coordinate recognition position upon actual wire bonding.

Referring to Fig. 15, the coordinate recognition for a corner having a contour with two straight lines perpendicular to each other is performed on the basis of a coordinate recognition reference point 8p. In this embodiment, the coordinate recognition can be corrected in a range of 2.25 mm at maximum in the x direction and of 1.8 mm at maximum in the y direction. However, a corner 7p of a conductor pattern of each of the ceramic substrates 7a and 7b is rounded for avoiding stress concentration (in this embodiment, R = 1 mm). In such an R corner, the boundary between the straight line for forming the coordinate recognition reference point and the contour line is unclear. For this reason, at the corner 7p, the termination of the R corner in contact with the straight line is taken as a reference point of a recognition mask 8m. In this case, the coordinate recognition can be corrected in a range of 1.0 mm at maximum in the x direction and of 0.55 mm at maximum in the y direction.

Fig. 16 is a typical view showing a limitation of coordinate recognition for wire bonding. A position at which a recognition area 8w projected on a screen is in contact with the recognition mask 8m becomes a limitation of coordinate recognition. That is, Δ x and Δ y are maximum allowable deviation dimensions for coordinate recognition in the x direction and y direction. If a positional deviation of 0.9 mm at maximum occurs between each of the ceramic substrates 7a and 7b and the power semiconductor device 9, such a deviation exceeds the recognition area 8w for wire bonding in the y direction, so that the coordinate recognition for wire bonding becomes difficult, resulting in occurrence of an error.

The soldering step shown in Figs. 6 and 7 requires the following tolerances and clearances: a clearance for setting the ceramic substrates 7a and 7b inside the inner end surface 73 of the jig 61 (0.1 mm); a work dimension tolerance of each of the ceramic substrates 7a and 7b (± 0.5 mm); a total of work dimension tolerances of a diameter of each module mounting hole 71 formed in the metal base 1a and each pitch between the holes 71 (±0.15 mm); a total of work dimension tolerances of a diameter of each pin 62 provided on the jig 61 and each pitch between the pins 62 (±0.1 mm); a clearance for inserting the pin 62 in the module mounting hole 71 (0.1 mm); a work dimension tolerance of the width of the metal base 1a (±0.15 mm); and a clearance for inserting the jig 61 inside the end surface 72 of the metal base 1a (0.1 mm), and accordingly, there occurs a positional deviation of 1.2 mm at maximum between the ceramic substrates 7a and 7b and the metal base 1a, and further, there occurs a positional deviation of 2.1 mm at maxim between the metal base 1a and the power semiconductor device 9 because the positional deviation of 0.9 mm at maximum at the above-described soldering step 1 is accumulated. The soldering step 3 requires the following tolerances and clearance: a work dimension tolerance of the case 6a (±0.2 mm); a work dimension tolerance of the width of the metal base 1a (±0.15 mm); and a clearance for inserting the case 6a in the metal base 1a (0.1 mm). As a result, by addition of the above work dimension tolerances and the clearances required for assembly, there occur a positional deviation of 0.45 mm at maximum between the case 6a and the metal base; a positional deviation of 1.65 mm at maximum between the case 6a and the ceramic substrates 7a and 7b; and a positional deviation of 2.55 mm at maximum between the case 6a and the power semiconductor device 9. Since the main terminals 2a and the pin terminals 10a are soldered with the conductor circuit patterns of the ceramic substrates 7a and 7b which are in turn soldered with the metal base 1a on the basis of the case 6a, the positional deviation of the ceramic substrates 7a and 7b exerts adverse effect on the assembly of the module.

Further, at the soldering step 2 shown in Fig. 6, a gap is formed between the metal base 1a and the jig 61 depending on warping of the metal base 1a, tilting and/or floating of the jig 61, and the like, which leads to excessive flow of the solder 21. This exerts adverse effect on assembly between the case 6a and the metal base 1a, and also it makes thin a solder layer between the ceramic substrates 7a and 7b and the metal base 1a, to cause voids in solder, thereby reducing the service life of soldering. Further, since the pin terminals 10a and the control terminals 4a are inserted in the through-holes of the circuit substrate 12a on which the control circuit is mounted and soldered thereto, the positional deviation of the pin terminals 10a exerts adverse effect on assembly of the control circuit substrate 12a. The pin terminals 10a are required to be individually provided on the ceramic substrates 7a and 7b, so that it is difficult to solder the pin terminals 10a in a state in which they are accurately arranged.

Since the number of the pin terminals 10a to be inserted in the control circuit apart from power circuit position substrate 12a (the total number containing the number of the control terminals 4a is 39) and also the pin terminals 10a are arranged with irregular pitches, the workability in assembling the pin terminals 10a is poor. The pin terminals 10a required to electrically connect the power circuit to the control circuit are connected to the conductor patterns of the ceramic substrates 7a and 7b and thereby they are arranged closely to the power circuit portion. As a result, the control circuit substrate 12a is liable to be affected by noise caused in the power circuit portion through the pin terminals 10a. In this case, since the area of the control circuit substrate 12a positioned over the power circuit is large, the control circuit substrate 12a is largely affected by noise caused in the power circuit.

The conductor patterns formed on the ceramic substrates 7a and 7b must be soldered with the pin terminals 10a in consideration of both a positional deviation of the substrates 7a and 7b and a positional deviation of the pin terminals 10a, so that the width of each conductor pattern is required to be widened. As a result, the ratio of the area of the conductor patterns to the total area of the ceramic substrates 7a and 7b becomes larger. It is difficult to make fine each of the conductor circuit patterns formed on the ceramic substrates 7a and 7b depending on the joining strength between the conductor pattern and the ceramic material, thickness of the conductor, and etching for forming the conductor circuit pattern. Since the ceramic substrates 7a and 7b function not only to constitute the power circuit portion but also to radiate heat generated from the power semiconductor devices 9 outside the module through the metal base 1a, the thickness of the ceramic substrate must be thinned for reducing the thermal resistance thereof. Accordingly, the increased dimensions of the ceramic substrates 7a and 7b in the longitudinal and lateral directions cause occurrence of warping of the ceramic substrates. Further, since the pin terminals 10a are arranged in two rows on both sides of the ceramic substrates 7a and 7b to be electrically connected to the control circuit substrate 12a, the control circuit substrate 12a becomes larger. As a result, when the silicon gel 13 is poured, bubbles are liable to be trapped by the circuit substrate 12a and gel voids are generated by remaining bubbles, leading to an insulation failure.

### SUMMARY OF THE INVENTION

The above-described prior art problems are considered in the present invention, and the present invention provides a high reliability structure of a power semiconductor module.

A power semiconductor module according to the present invention comprises a metal base, plural wiring substrates provided on the metal base, a first wiring substrate of the wiring substrates having a power circuit portion including a power semiconductor device, and a substrate containing portions having a resin portion in which one of the wiring substrstes is contained. This one of said wiring substrates is positioned in self-alignment on the metal substrate on the basis of an inner wall of the resin portion of the substrate containing portion.

Specifically, according to the present invention, there is provided a power semiconductor module which adopts a base-integral type case formed by molding a resin in a die integrally with a base substrate and terminals previously inserted in the die, wherein substrate containing portions, each of which is surrounded by a resin portion, specialized for containing respective substrates are formed on a metal base. To be more specific, a ceramic substrate constituting a power circuit and a circuit substrate for mounting a control substrate are separated from a control terminal wiring portion electrically connected to the power circuit, and these two separated portions are respectively disposed in the above substrate containing portions. The ceramic substrate containing portion is also formed with a step for containing the ceramic substrates in such a manner that the ceramic substrates are deviated from each other for avoiding interference between an inner wall of a case corner and a wire bonding tool and for positioning between the ceramic substrates. Further, projections are provided on the inner wall of each substrate containing portion for positioning the substrate with respect to the case in self-alignment, and for preventing close contact between the inner wall of the case and the substrate, to promote permeation of silicon gel, thereby avoiding occurrence of gel voids.

A jig is inserted in a resin frame of the substrate containing portion for positioning power semiconductor devices with respect to the case. The resin frame of the substrate containing portion is effective to perfectly prevent excessive flow of solder and hence to prevent adverse effect, induced by the excessive flow of solder, exerted on other components, and also to avoid deficiency of solder and occurrence of voids in solder caused by excessive flow of solder and hence to improve the reliability at portions joined by soldering.

By disposing the control terminal wiring portion separated from the power circuit on one side of the module and making small the area of the control circuit substrate, it is possible to reduce the effect of noise caused in the power circuit, and to reduce bubbles trapped by the control circuit substrate and hence to avoid occurrence of gel voids. The control terminals for electrically connecting the control circuit substrate to the power substrate are arranged in a line with a specific pitch and fixed with a resin to form connection terminals. The connection terminals are mounted on the control terminal wiring substrate provided with wiring bonding pads to be wired to the power circuit. A printed wiring substrate is used for the control terminal wiring portion to miniaturize the substrate by fine wiring patterns. With such miniaturization of the substrate and the configuration of a wiring pattern of the wiring substrate, an IPM and a PM can be modified from each other using the common power circuit and case.

In the case where the above wiring substrate is composed of a circuit substrate serving as a wiring substrate by mounting a control circuit on a multi-layer printed wiring substrate and is disposed in the wiring substrate containing portion provided on the metal base, it is possible to eliminate bubbles trapped by the control circuit substrate and hence to avoid occurrence of gel voids and reduce the poured amount of silicon gel.

Further, according to the present invention, there can be obtained a structure in which the control circuit substrate positioned over the power circuit is eliminated to thereby significantly reduce the effect of noise caused in the power circuit, and also each substrate can be easily, highly accurately positioned and assembled with respect to the case in self-alignment on the basis of the above substrate containing portion.

### Brief Description of the Drawings

Fig. 1 is a bird's eye view showing an IPM structure and a process of assembling the IPM structure in an embodiment of the present invention.

Fig. 2 is a plan view showing one example of a prior art IPM structure.

Fig. 3 is a sectional view showing the example of the prior art IPM structure.

Fig. 4 is a plan view of a jig assembly showing the content of a prior art soldering work.

Fig. 5 is a sectional view of the jig assembly showing the content of the prior art soldering work.

Fig. 6 is a plan view of the jig assembly showing the content of the prior art soldering work.

Fig. 7 is a sectional view of the jig assembly showing the content of the prior art soldering work.

Fig. 8 is a plan view showing an IPM structure according to an embodiment of the present invention.

Fig. 9 is a sectional view showing the IPM structure according to the embodiment of the present invention.

Fig. 10 is a plan view showing details of a ceramic substrate containing portion according to the embodiment of the present invention.

Fig. 11 is a detailed view showing positioning between ceramic substrates according to the embodiment of the present invention.

Fig. 12 is a sectional detailed view showing positioning between the ceramic substrates according to the embodiment of the present invention.

Fig. 13 is a plan view showing details of a ceramic substrate containing portion according to an embodiment of the present invention.

Fig. 14 is a view showing a positional relationship between a wire bonding tool and a case according to an embodiment of the present invention.

Fig. 15 is a typical view showing a coordinate recognition reference for wire bonding according to an embodiment of the present invention.

Fig. 16 is a typical view showing a limitation of coordinate recognition for wire bonding according to an embodiment of the present invention.

Fig. 17 is a typical plan view showing details of a ceramic substrate containing portion according to a prior art structure.

Fig. 18 is a typical sectional view showing interference between ceramic substrates according to the prior art structure.

Fig. 19 is a typical sectional view showing a state in which gel voids occur according to the prior art structure.

Fig. 20 is a plan view showing details of a wiring substrate containing portion of an IPM according to an embodiment of the present invention.

Fig. 21 is a plan view showing details of a wiring substrate containing portion of a PM according to an embodiment of the present invention.

Figs. 22(a) to 22(c) are sectional views showing a procedure of assembling an IPM according to an embodiment of the present invention.

Figs. 23(d) to 23(e) are sectional views showing the procedure of assembling the IPM according to the embodiment of the present invention.

Fig. 24 is a sectional view in perspective of a jig assembly showing soldering of an IPM according to an embodiment of the present invention.

Fig. 25 is a sectional view of a jig assembly showing soldering of the IPM according to the embodiment of the present invention.

Fig. 26 is a view showing an appearance the IPM according to the embodiment of the present invention.

Fig. 27 is a detailed sectional view in perspective of a lid fitting structure according to the embodiment of the present invention.

Fig. 28 is a plan view showing a PM structure according to an embodiment of the present invention.

Fig. 29 is a sectional view showing the PM structure according to the embodiment of the present invention.

Fig. 30 is a plan view showing an IPM structure according to an embodiment of the present invention.

Fig. 31 is a sectional view showing the IPM structure according to the embodiment of the present invention.

Fig. 32 is a plan view showing an IPM structure according to an embodiment of the present invention.

Fig. 33 is a sectional view showing the IPM structure according to the embodiment of the present invention.

Fig. 34 is a detailed sectional view in perspective of a lid fitting structure according to an embodiment of the present invention.

### DESCRIPTION OF THE PREFERRED EMBODIMENTS

Hereinafter, embodiments of the present invention will be described with reference to the drawings.

### (Embodiment 1)

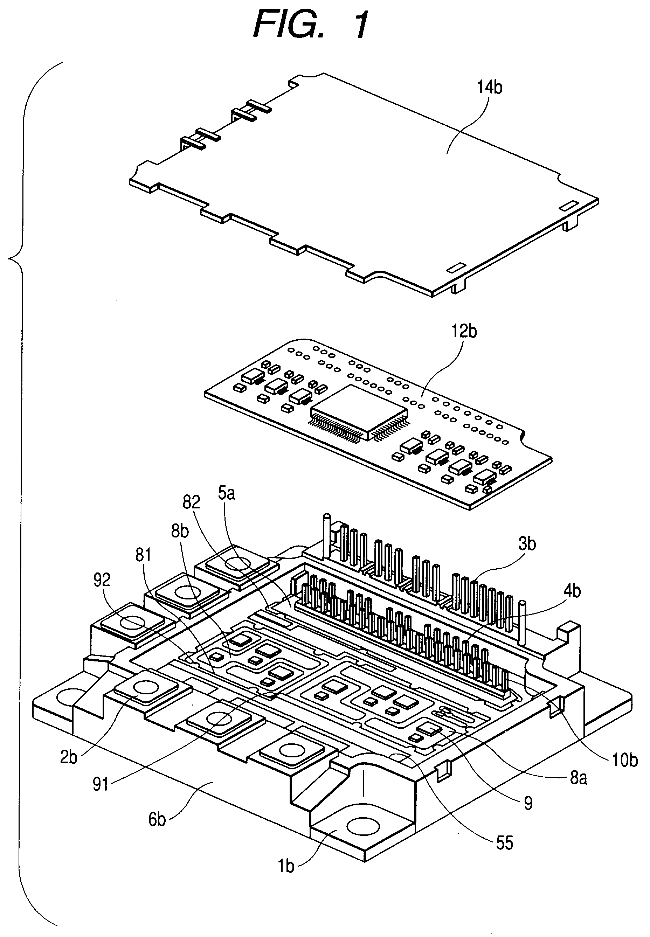

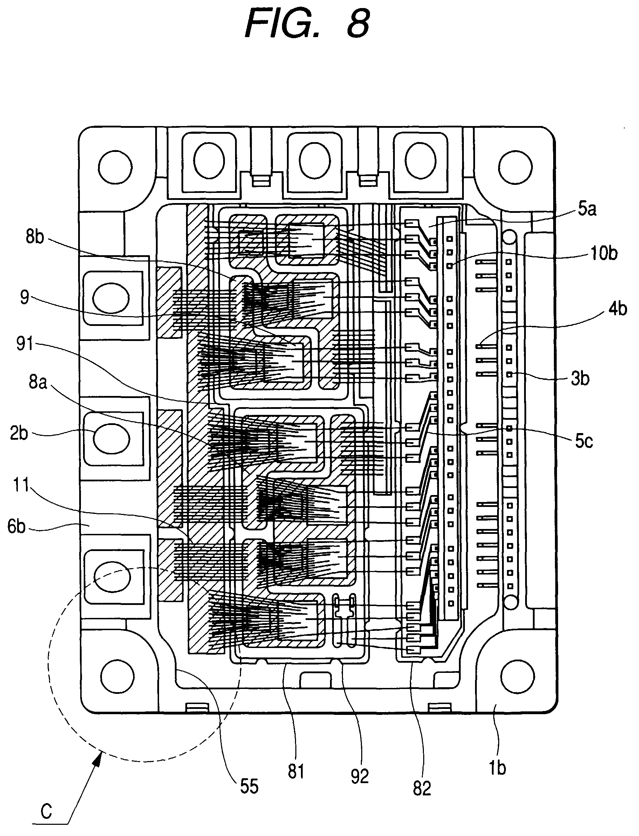

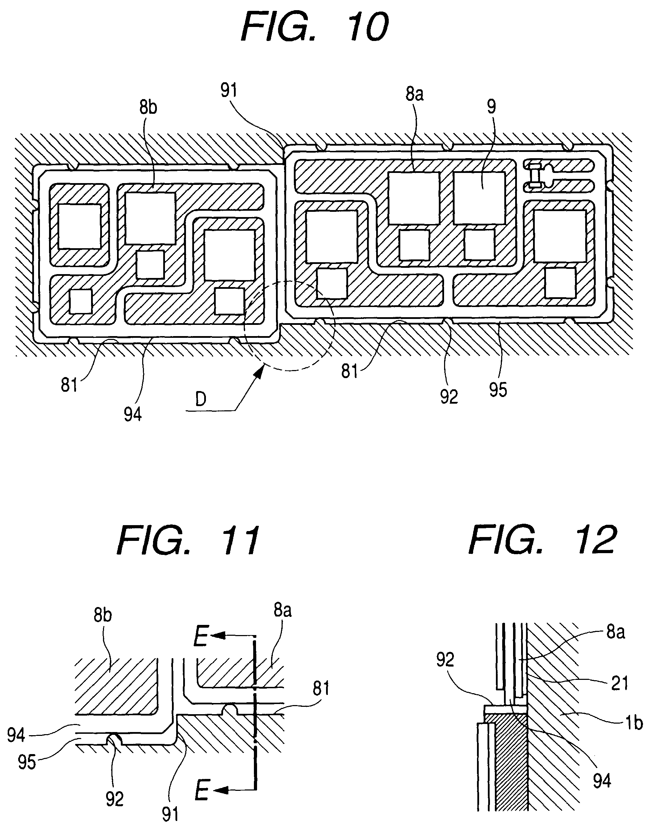

Fig. 1 is a bird's eye view showing an IPM structure and a process of assembling the IPM structure; and Figs. 8 and 9 are a plan view and a sectional view of the IPM structure shown in Fig. 1, respectively. In this embodiment, a case 6b is a base-integral type case formed by molding a resin in a die with a metal base 1b, main terminals 2b, and control terminals 3b previously inserted in the die. A ceramic substrate containing portion 81 and a wiring substrate containing portion 82, each of which is surrounded with a resin portion, are formed on the metal base 1b of the base-integral type case 6b, and wiring planes of the main terminals 2b and input/output control terminals 4b for the module are arranged on both sides of the case 6b, respectively. Thus, the ceramic substrate containing portion 81 and the wiring substrate containing portion 82 specialized for containing ceramic substrates and a wiring substrate respectively, are formed.

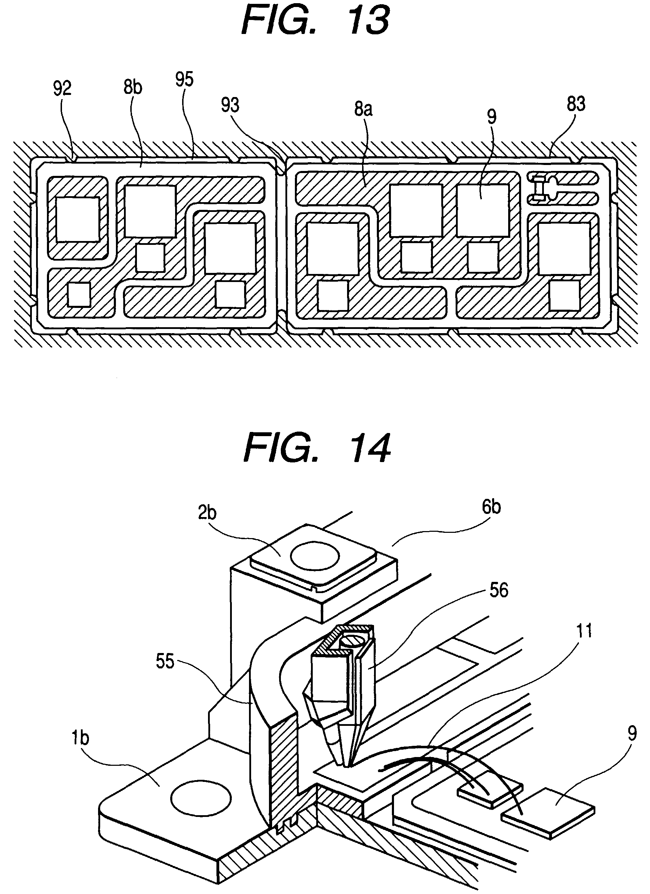

Fig. 10 is a detailed plan view of the ceramic substrate containing portion; Fig. 11 is a detailed view of a portion D shown in Fig. 10; Fig. 12 is a sectional view taken on line E-E of Fig. 11; and Fig. 14 is a perspective view showing a positional relationship between a wire bonding tool and an inner wall of the case at an inner corner portion C of the case shown in Fig. 8. In this embodiment, the ceramic substrate containing portion 81 shown in Fig. 10 has a resin frame with a step 91 for containing ceramic substrates 8a and 8b in such a state that both the substrates 8a and 8b are deviated from each other. The step 91 is used for positioning between the ceramic substrates 8a and 8b. Also the deviation of the ceramic substrate 8a in the direction apart from a case corner 55 is effective to avoid interference between a wire bonding tool 56 and an inner wall of the case corner 55 upon wire bonding work. The positioning between the case 6b and the ceramic substrates 8a and 8b is performed by means of projections 92 provided on the inner wall of the ceramic substrate containing portion 81. At this positioning, a gap 95 is provided around the outer peripheries of the ceramic substrates 8a and 8b, more specifically, between the inner wall of the ceramic substrate containing portion 81 and end surfaces 94 of the ceramic substrates 8a and 8b.

Hereinafter, there will be described the reason why the projections 92 and the step 91 for positioning between the ceramic substrates are provided on the ceramic substrate containing portion 81.

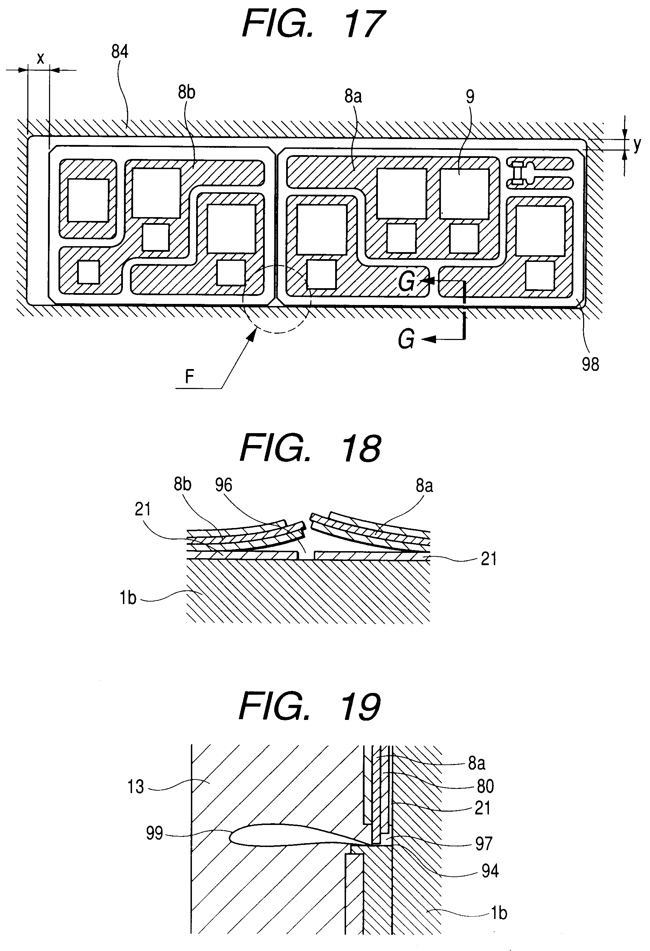

Fig. 17 is a typical view showing a deviation of ceramic substrates contained in a ceramic substrate containing portion with no step for positioning between the substrates and no projections; Fig. 18 is a typical sectional view showing details of a portion F of Fig. 17; and Fig. 19 is a typical sectional view taken on line G-G of Fig. 17. The ceramic substrate 8a or 8b has a large work dimension tolerance because of characteristics of a ceramic material thereof. Accordingly, if the positional relationship between the ceramic substrates 8a and 8b is not fixed, there may occur a deviation of the ceramic substrates 8a and 8b at one corner of a ceramic substrate containing portion 84 upon assembling and soldering works of the ceramic substrates. In this embodiment, a positional deviation of the ceramic substrates 8a and 8b in the x direction shown in Fig. 17 becomes 1.5 mm at maximum by addition of the following tolerances and clearances: a work dimension tolerance of the ceramic substrate 8a (±0.4 mm); a work dimension tolerance of the ceramic substrate 8b (±0.3 mm); a work dimension tolerance of the ceramic substrate containing portion 84 (±0.2 mm); a clearance for setting the substrates 8a and 8b in the ceramic substrate containing portion 84 (0.1 mm); and a minimum clearance between the ceramic substrates 8a and 8b for promoting permeation of silicon gel 13 and avoiding occurrence of gel voids. A positional deviation of the ceramic substrates 8a and 8b in the y direction in Fig. 17 becomes 0.5 mm at maximum by addition of tolerances and a clearance: a work dimension tolerance of the ceramic substrates 8a and 8b (± 0.25 mm); a work dimension tolerance of the ceramic substrate containing portion 84 (±0.15 mm); and a clearance for setting the substrates 8a and 8b in the ceramic substrate containing portion 84 (0.1 mm)

As compared with an accuracy of positioning between the case using the prior art jig and the ceramic substrates, the positional deviation y can be reduced one-third or less at maximum; however, the positional deviation x remains unchanged because an error of the ceramic substrate 8b is accumulated to an error of the ceramic substrate 8a. With such a large positional deviation x, a recognition mask 8m in coordinate recognition for wire bonding shown in Fig. 15 may exceed a coordinate recognition area 8w in the x direction. This makes it difficult to recognize coordinate values of each conductor pattern corner 7p of the ceramic substrates 8a and 8b upon wire bonding work. As a result, there occurs an error exceeding a deviation Δx in a coordinate recognition limit range shown in Fig. 16. Further, the wiring plane of each main terminal 2b is susceptible to covering of resin due to positional deviation caused by deflection of the terminal plane upon resin-molding and to sagging of an end surface of the terminal 2b upon pressing thereof, so that it is difficult to take a corner of the wiring plane of the main terminal 2b as a coordinate recognition reference position for wire bonding. As a result, the wire bonding position of the main terminal 2b is relatively set on the basis of the conductor pattern corner 7p of the ceramic substrates 8a and 8b. The positional deviation of the ceramic substrates 8a and 8b thus directly exerts effect on the wire bonding position of the main terminal 2b, that is, causes a deviation of the wire bonding position, which leads to a bonding failure upon wire bonding.

Additionally, each of the ceramic substrates 8a and 8b, which is thin (0.28 mm in this embodiment), tends to warp at the preparation step thereof. In the case where the positional relationship between the ceramic substrates 8a and 8b is not fixed, if there occurs a positional deviation therebetween, the ceramic substrates 8a and 8b are superimposed to each other due to warping of the ceramic substrates 8a and 8b, and also a gap 96 is formed due to contact between the ceramic substrates 8a and 8b and/or contact between the ceramic substrates 8a and 8b and the ceramic substrate containing portion 84. The gap 96 obstructs permeation of the silicon gel 13 when the silicon gel 13 for insulation is poured in the package, so that bubbles are liable to remain in the gap 96, to cause a gel void 99, leading to a failure in insulation. Further, since a copper foil 80 provided on the back surface of each of the ceramic substrates 8a and 8b for soldering the ceramic substrate to the metal base 1b is positioned inside a substrate end surface 94 (1 mm in this embodiment) in consideration of preparation of the ceramic substrate, a gap 97 is formed when the substrate 8a or 8b is in close-contact with the inner wall of the substrate containing portion 84 even in the case of a small warping of the ceramic substrate 8a or 8b. Like the gap 96, the gap 97 also obstructs permeation of the silicon gel 13, causing a gel void 99. In particular, bubbles remaining near a corner 98 at which two end surfaces of the ceramic substrate 8a are in contact with the inner wall of the substrate containing portion 84 are hardly released, tending to cause the gel void 99.

Consequently, the step 91 provided on the ceramic substrate containing portion 81 is required for fixing the movable positions of the ceramic substrates 8a and 8b closely to each other thereby preventing interference between the ceramic substrates 8a and 8b; individually positioning the ceramic substrates 8a and 8b in self-alignment with respect to the case without use of any jig; and improving the positioning accuracy of the ceramic substrates 8a and 8b with respect to the case, to allow coordinate recognition upon wire bonding work, thereby avoiding a coordinate recognition error and a failure in wire bonding of the wiring plane of the main terminal 2b due to a deviation of the ceramic substrates 8a and 8b. By measuring a dimensional deviation of each of the ceramic substrates being largest in work dimension tolerance among the module components and setting the optimum dimensions of the ceramic substrate containing portion based on the measured result, the positioning accuracy of the ceramic substrates with respect to the case can be reduced to be one-fourth or less than that in the prior art method, that is, 0.4 mm or less at maximum.

The projections 92 are required for positioning the ceramic substrates 8a and 8b with respect to the case 6b in self-alignment; preventing close-contact between the ceramic substrates 8a and 8b and the inner wall of the substrate containing portion and providing the gap 95 around the outer peripheries of the ceramic substrates 8a and 8b, thereby promoting permeation of the silicon gel 13 and avoiding a failure in insulation due to occurrence of a gel void. Further, since the ceramic substrates 8a and 8b are surrounded by the resin frame of the substrate containing portion, excessive flow of the solder 21 can be perfectly prevented, so that it is possible to avoid deficiency of solder and occurrence of voids in solder and hence to improve the reliability of the joined portions by soldering. In this embodiment, the projection 92 is formed in a semi-circular shape; however, the present invention is not limited thereto. For example, the projection 92 may be formed in a square shape with a narrow width or a triangular shape. Further, the number of the projections 92 for providing the gap 95 is not limited to that shown in Fig. 10.

The ceramic substrates 8a and 8b constituting the power circuit shown in Figs. 8 and 9 and the circuit substrate 12b for mounting the control circuit, and connection terminals 10b to be electrically connected to the power circuit portion and a wiring substrate 5a for mounting the connection terminals 10b, are independently disposed in the ceramic substrate containing portion 81 and the wiring substrate containing portion 82. In this embodiment, the wiring substrate 5a is separated from the power circuit portion and is disposed on one side of the case on the control terminal 3b side, and the area of the control circuit substrate 12b is made smaller to reduce the control circuit positioned over the power circuit, so that the effect of noise exerted on the power circuit can be reduced. Further, since the area of the control circuit substrate 12b is made smaller, when the silicon gel 13 is poured, the amount of bubbles trapped by the circuit substrate is reduced, to thereby avoid occurrence of gel voids. The connection terminals 10b for electrically connecting the circuit substrate 12b for mounting the control circuit to the power circuit portion are arranged in a line along the control terminals 4b with a specific pitch (2.54 mm in this embodiment) and are fixed with a resin.

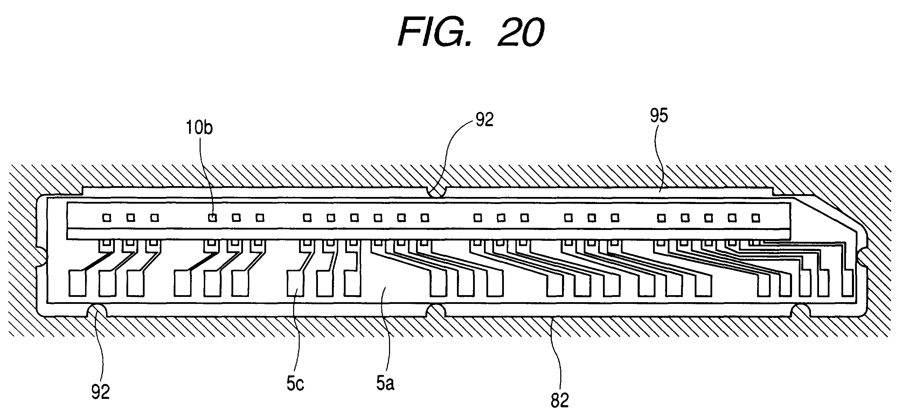

Fig. 20 is a detailed view showing the connection terminals 10b and the wiring substrate 5a. The wiring substrate 5a is represented by a printed wiring substrate allowing formation of fine patterns. The wiring substrate 5a is provided with bonding pads 5c which are wired with the power semiconductor elements 9 using the metal wires 11 by wire bonding. The ceramic substrates constituting the power circuit are separated from the wiring substrate 5a for mounting the connection terminals 10b and are wired by the metal wires 11 by wire bonding, and accordingly, even if a positional deviation of the ceramic substrates 8a and 8b occurs due to the above-described work dimension tolerances and clearances required for assembly, the connection terminals 10b connected to the control circuit substrate 12b are not affected by the positional deviation of the ceramic substrates 8a and 8b. Like the ceramic substrate containing portion 81, the wiring substrate containing portion 82 for containing the wiring substrate 5a is surrounded by a resin portion, so that it is possible to perfectly obstruct excessive flow of solder and hence to avoid deficiency of solder and occurrence of voids in solder, and also to prevent adverse effect induced by the excessive flow of solder from being exerted on the ceramic substrates 8a and 8b. Further, projections 92 are also provided on the wiring substrate containing portion 82 for positioning the wiring substrate 5a in self-alignment, and for providing a gap 95 between the inner wall of the wiring substrate containing portion 82 and the wiring substrate 5a. The gap 95 is effective to promote permeation of the silicon gel 13 and hence to avoid occurrence of gel voids.

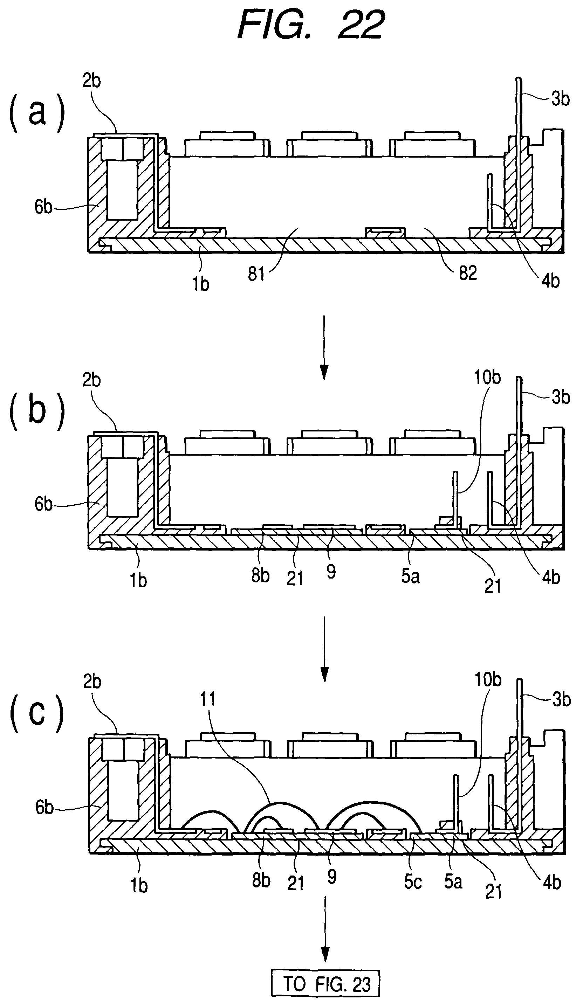

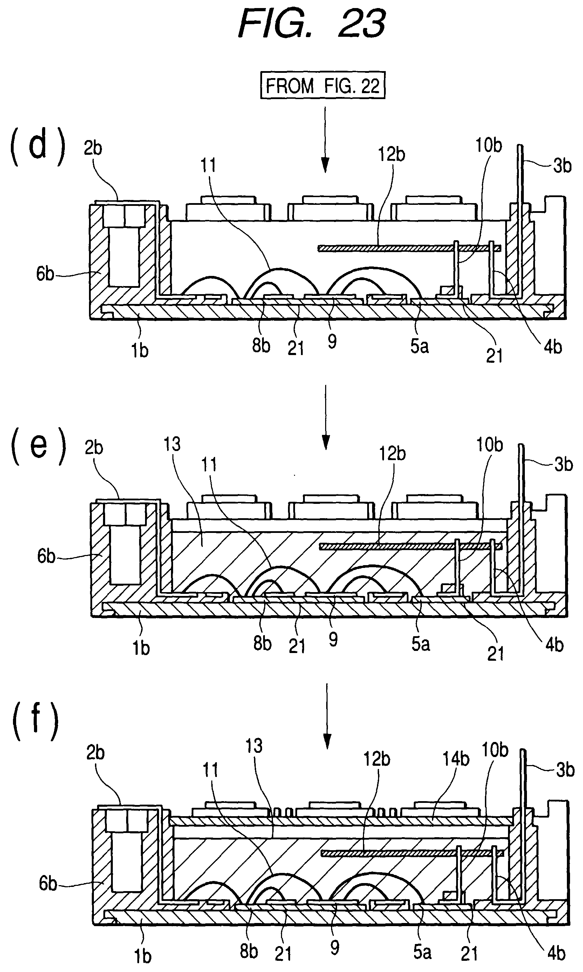

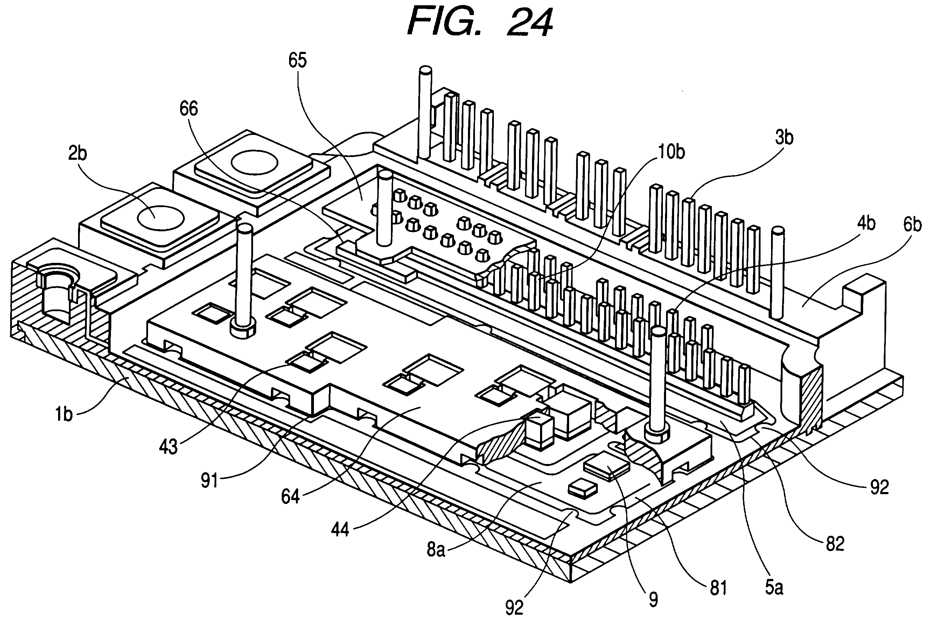

Figs. 22(a), 22(b) and 22(c) and Figs. 23(d), 23(e) and 22(f) are sectional views showing an assembling procedure for an IPM using the IPM case of the present invention; Fig. 24 is a sectional view in perspective of a state of positioning of the ceramic substrates and the wiring substrate and a jig assembling state; and Fig. 25 is a sectional view of Fig. 24. The assembly of the IPM is performed as follows. First, an assembling state shown in Figs. 24 and 25 is obtained using the base-integral type case 6b shown in Fig. 22(a). Specifically, a solder sheet 21 is placed on the metal base 1b at the ceramic substrate containing portion 81 provided in the base-integral type case 6b, and the ceramic substrates 8a and 8b are set on the solder sheet 21. At this time, the ceramic substrates 8a and 8b are positioned in self-alignment on the basis of the step 91 and the projections 92 provided on the ceramic substrate containing portion 81. A carbon made jig 64 is inserted inside the inner wall of the ceramic substrate containing portion 81 in which the solder sheet 21 and the ceramic substrates 8a and 8b are contained, to perform positioning between the case 6b and the jig 64. Solder sheets 20 and the power semiconductor devices 9 are set in square holes 43 provided in the jig 64, and then weights 44 are placed thereon for preventing deviations of the power semiconductor devices 9 and improving wetting spread of the solder 20.

Since the power semiconductor devices 9 are positioned using the jig 64 on the basis of the ceramic substrate containing portion 81 provided in the case 6b, it is possible to improve the positional accuracy between the case and each of the power semiconductor devices 9 to a degree of one-tenth or less than that in the prior art method, that is, 0.25 mm or less at maximum. The solder sheet 21 is placed on the metal base 1b at the wiring substrate containing portion 82, and the wiring substrate 5a on which the connection terminals 10b are previously soldered is set on the solder sheet 21. At this time, the wiring substrate 5a is positioned in self-alignment on the basis of the above-described projections 92. A jig 65 is mounted inside the case 6b. At this time, the control terminals 4b raised at right angles and the connection terminals 10b are inserted in through-holes formed in the jig 65, to perform positioning between the jig 65 and the connection terminals 10b on the basis of the control terminals 4b fixed on the case 6b with a resin. A stand 66 provided on the jig 65 is placed as a weight on the wiring substrate 5a for preventing a deviation of the wiring substrate 5a due to a work dimension error thereof and improving wetting spread of the solder 21. The ceramic substrates 8a and 8b, power semiconductor devices 9, wiring substrate 5a, and connection terminal 10b thus assembled inside the case 6b are soldered by reflow of the solder together with the jig. Such a state is shown in Fig. 22(b).

The soldering work shown in Fig. 22(b) is followed by wiring using the metal wires 11 by wire bonding between the power semiconductor devices 9 and the wiring planes of the main terminals 2b disposed on both sides of the ceramic substrate containing portion 81, between the power semiconductor devices 9 and the conductor patterns of the ceramic substrates 8a and 8b, and between the power semiconductor devices 9 and the bonding pads 5c provided on the wiring substrate 5a. Such a state is shown in Fig. 22(c). Next, the connection terminals 10b and the control terminals 4b are inserted in through-holes provided in the circuit substrate 12b for mounting the control circuit, and soldered thereto. Such a state is shown in Fig. 23(d). In this embodiment, since the connection terminals 10b are disposed on one side of the module and the control circuit substrate 12b is miniaturized and further the through-holes of the substrate 12b are arranged in a line with a specific pitch, it is possible to improve a perforating accuracy and a workability in assembling with the terminals.

After completion of wiring and soldering shown in Fig. 23(d), the silicon gel 13 is poured in this package and hardened. Such a state is shown in Fig. 23(e). Then, a lid 14b is mounted on the package, to obtain an IPM shown in Fig. 23(f).

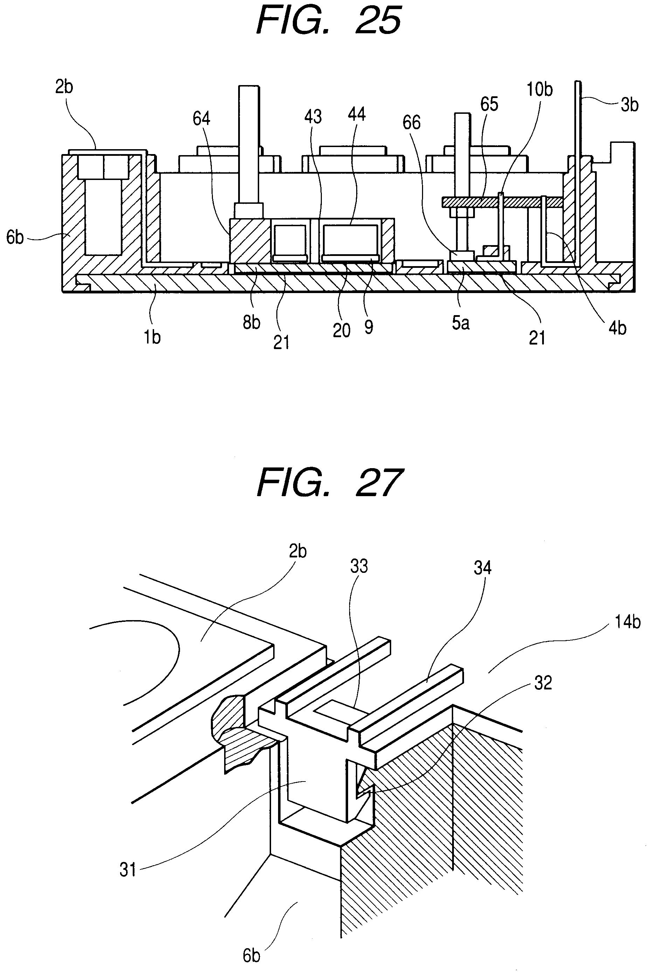

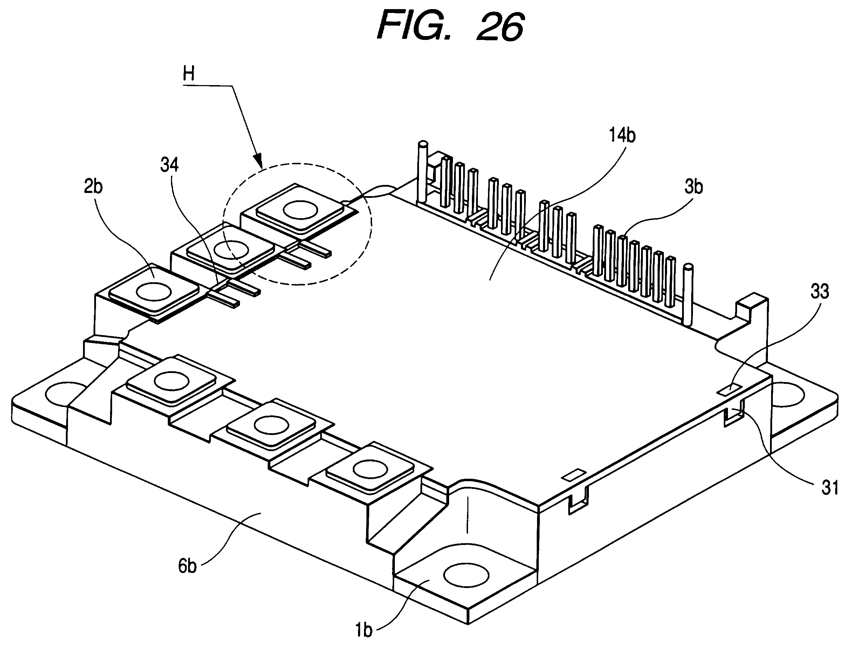

Fig. 26 is a bird's eye view of the IPM thus completed, and Fig. 27 is a detailed sectional view in perspective view of a lid mounting structure at a portion H shown in Fig. 26. The lid mounting structure is of a so-called snap-fit type in which each inner claw 31 provided on the lid 14b is fitted with the corresponding outer claw 32 provided on the case 6b in a self-lock manner by a spring force of the inner claw 31. To easily release a molded lid from a die after resin-molding, a square hole 33 is formed in an upper portion of each inner claw 31 for avoiding undercut upon resin-molding. A gap between the main terminals 2b at the portion H in Fig. 26 is narrow, and accordingly, the provision of the square hole 33 in the inner claw 31 positioned between the main terminals 2b may cause breakage of the inner claw 31 upon assembly of the lid 14b. To cope with such an inconvenience, ribs 34 for ensuring an insulating distance between the main terminals 2b and reinforcing the inner claw 31 are provided on both sides of the square hole 33, to thereby prevent the breakage of the inner claw 31.

### (Embodiment 2)

Fig. 13 is a detailed view of a ceramic substrate containing portion for linear arrangement of ceramic substrates. The ceramic substrate containing portion 81 in Embodiment 1 is adapted to contain the ceramic substrates 8a and 8b which are deviated from each other. This embodiment can be applied to the case where there is no interference between the inner wall of the case corner 55 shown in Fig. 14 and the wire bonding tool 56 or the number of the ceramic substrates is further increased. In this embodiment, positioning between the ceramic substrates 8a and 8b is performed by projections 93 provided on a ceramic substrate containing portion 83.

In this embodiment, there is shown an arrangement of two pieces of the ceramic substrates; however, in the case of an arrangement of three pieces or more of ceramic substrates, there can be adopted not only the configuration shown in Fig. 13 but also the combination of the ceramic substrate containing portion 81 provided with the step in Embodiment 1 and the substrate containing portion 83 provided with the projections. Further, although each of the projections 93 for positioning between the ceramic substrates is formed in an elongated semi-circular shape in this embodiment; however, the present invention is not limited thereto. For example, the projection 93 may be formed in a triangular or circular-arc shape with the corners of the ceramic substrates 8a and 8b taken as guides. Further, in the case where a gap between ceramic substrates is sufficiently large, the projections 93 may be taken as a resin frame to form independent ceramic substrate containing portions, and terminal planes for wiring may be disposed on the resin frame between the substrates. In this way, the present invention is not limited to the resin frame and the shape of the projection shown in Fig. 13.

In a power semiconductor module such as this embodiment and the following embodiments, a projection formed on the periphery of a wiring substrate such as the ceramic substrate can be used for positioning the wiring substrate on the metal base as well as the projections of the resin frame.

### (Embodiment 3)

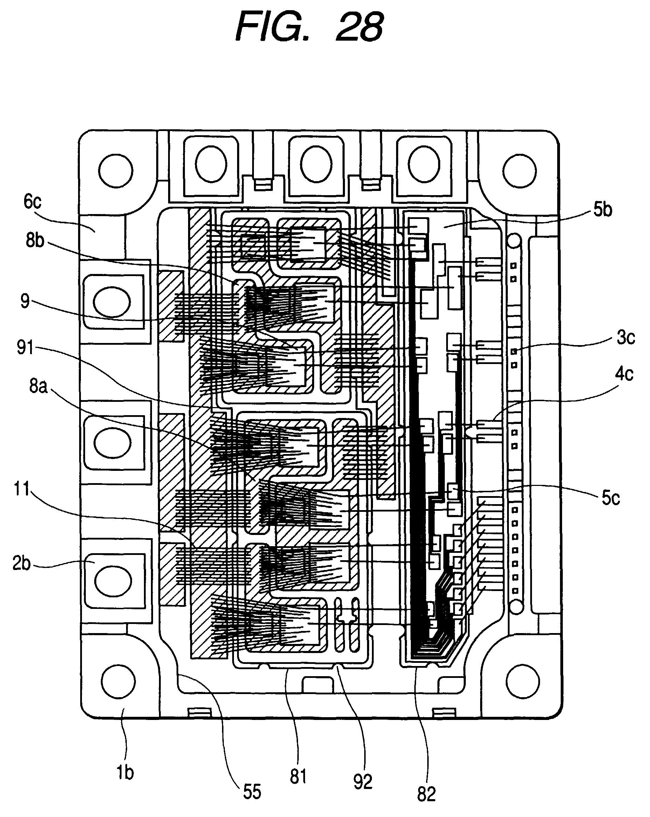

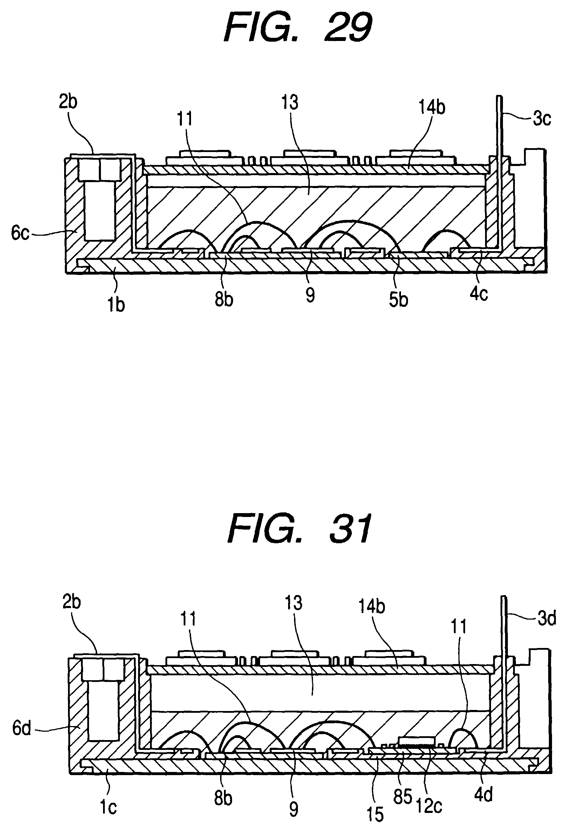

Fig. 28 is a plan view showing a PM structure, and Fig. 29 is a sectional view of the PM structure. A case 6c is the same as the case 6b shown in Embodiment 1 except for control terminals 3c. Each of the input/output control terminals 3c is folded in an L-shape to form a bonding pad 4c inside the case 6c. The case 6c can be formed by resin-molding using the die for forming the case 6b by resin-molding, wherein control terminal 4c portions in the die are replaced with inserts. A ceramic substrate containing portion 81 constitutes a power circuits using the same ceramic substrates 8a and 8b as those in Embodiment 1. In a wiring substrate containing portion 82, the wiring substrate 5a for mounting the connection terminals shown in Embodiment 1 is replaced with a printed wiring substrate 5b specialized for wiring.

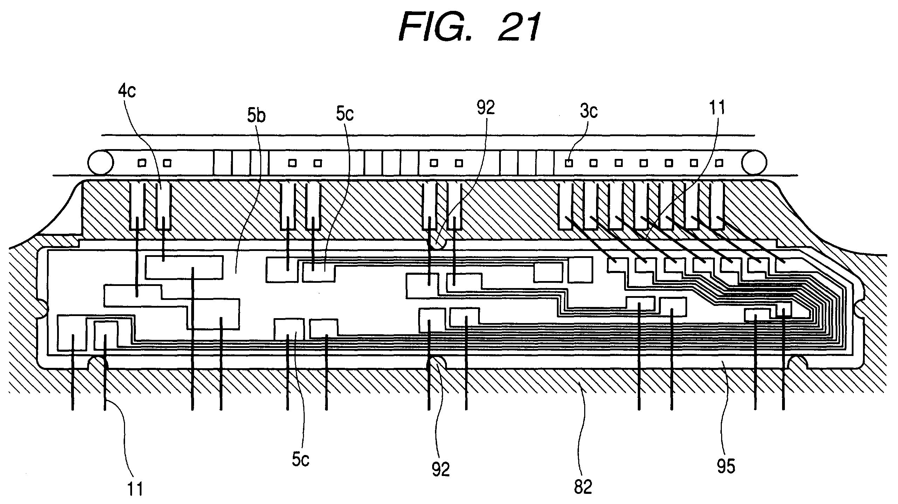

Fig. 21 is a detailed plan view of the substrate 5b specialized for wiring. Power semiconductor devices 9 constituting the power circuit are wired with bonding pads 5c provided on the substrate 5b using metal wires 11 by wire bonding, and the bonding pads 5c are wired with the bonding pads 4c provided on the control terminals 3c using the metal wires 11 by wire bonding, to obtain a PM. In this embodiment, the PM can be modified from IPM by using the configuration of the power circuit commonly to the IPM and the PM, unifying the wiring direction of the metal wires 11, and using the substrate 5b specialized for wiring and the case 6c.

### (Embodiment 4)

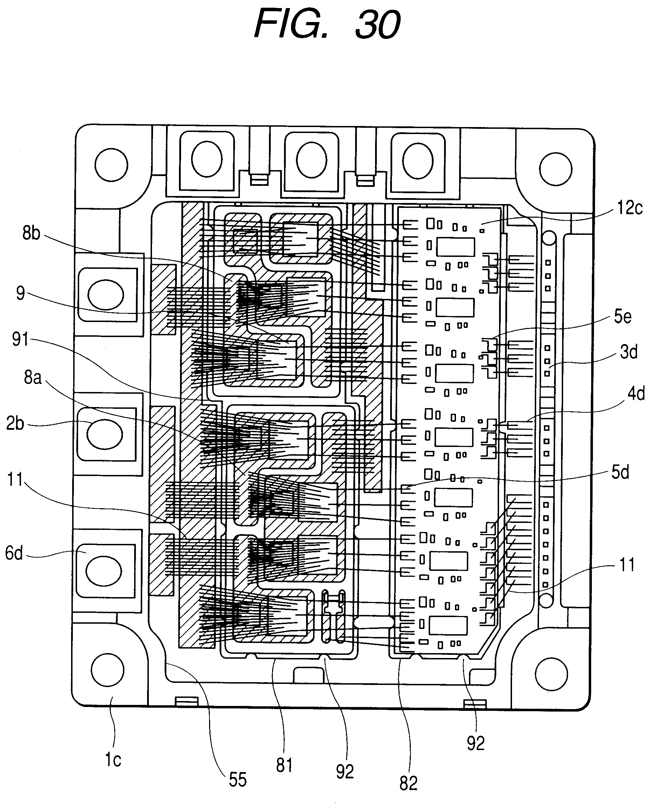

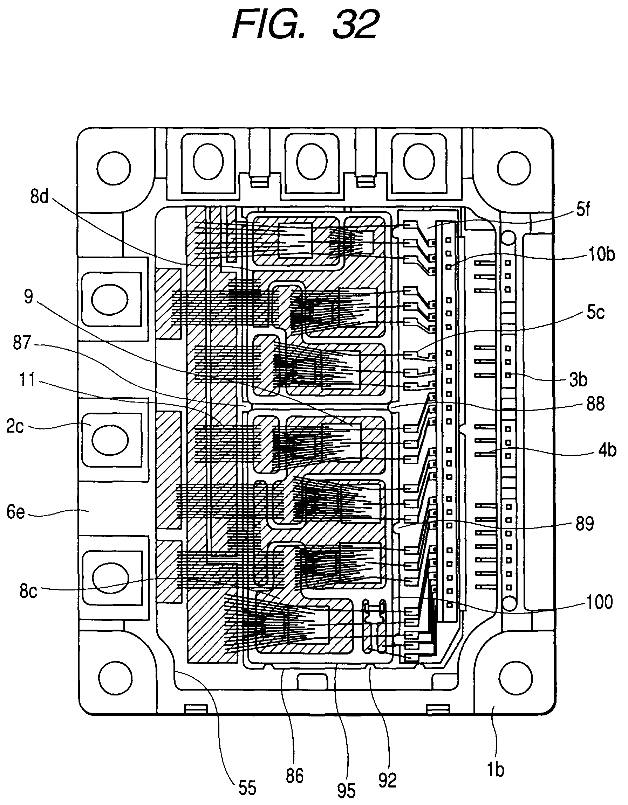

Fig. 30 is a plan view showing another embodiment of the IPM, and Fig. 31 is a sectional view of the IPM. In Embodiment 1, there is shown the IPM structure in which the circuit substrate for mounting the control circuit is provided in a space inside the case. In this embodiment, there is shown a configuration in which the width of the above-described wiring substrate containing portion 82 is widened and a circuit substrate 12c for mounting a control circuit is disposed in the wiring substrate containing portion 82. Control terminals 3d are the same as the control terminals 3c shown in Embodiment 3, and bonding pads 4d are formed inside the case 6d. Like Embodiment 1, the case 6d is a base-integral type case in which a ceramic substrate containing portion 81 and the wiring substrate containing portion 82, each of which is surrounded with a resin portion, are formed on a metal base 1c. The circuit substrate 12c for mounting the control circuit is provided with bonding pads 5d and 5e on both sides thereof. That is, the circuit substrate 12c serves as a wiring substrate formed with wiring patterns, and is disposed in the wiring substrate containing portion 82.

In the case where the area of the control circuit substrate 12c is allowed to be sufficiently large, wiring patterns can be formed only on an upper surface of the circuit substrate 12c, and the circuit substrate 12c can be soldered on the metal base 1c. However, to miniaturize the control circuit substrate 12c, the control circuit substrate 12c is required to be composed of a multi-layer printed wiring substrate in which wiring patterns are formed in multi-layers. In the multi-layer printed wiring substrate, electric connection between wiring patterns between layers is performed via through-holes, and accordingly the through-holes are exposed from the back surface of the printed wiring substrate. As a result, the multi-layer printed substrate cannot be directly soldered or bonded on the metal base 1c from the electric viewpoint. To cope with such an inconvenience, in this embodiment, a resin layer 85 is formed, together with a resin frame of the wiring substrate containing portion 82, on the ground of the wiring substrate containing portion 82, so that the control circuit base 12c composed of the multi-layer printed substrate can be electrically insulated from the metal base 1c. The control circuit substrate 12c is fixed on the resin layer 85 with adhesive 15. Like Embodiment 1, the ceramic substrate containing portion 81 contains power semiconductor devices 9 and ceramic substrates 8a and 8b, to constitute a power circuit. The power semiconductor devices 9 are wired with the bonding pads 5d provided on the control circuit substrate 12c using metal wires 11 by wire bonding, and the bonding pads 5e are wired with the bonding pads 4d provided on the control terminals 3d using the metal wires 11 by wire bonding, to constitute an IPM.

Like Embodiment 3, by replacing the control circuit substrate 12c with a substrate specialized for wiring, the IPM can be modified into a PM using the same case 6d. In this embodiment, since the control circuit substrate 12c is disposed on the metal base 1c, when the silicon gel 13 is poured as described in Embodiment 1, bubbles trapped by the circuit substrate 12c can be eliminated, so that it is possible to avoid occurrence of gel voids and reduce the poured amount of the silicon gel. Further, since the control circuit substrate 12c positioned over the power circuit is eliminated, it is possible to significantly reduce an effect of noise caused in the power circuit portion.

Like Embodiment 1, the ceramic substrate containing portion 81 is assembled by positioning the power semiconductor devices 9 with respect to the case 6d using a carbon made jig 64, and positioning the ceramic substrates 8a and 8b with respect to the case 6d in self-alignment using a step 91 and projections 92 provided in the ceramic substrate containing portion 81, followed by soldering of the power semiconductor devices 9 and the ceramic substrates 8a and 8b. The control circuit substrate 12c can be easily, highly accurately positioned in the wiring substrate containing portion 82 in self-alignment using projections 92 provided on the substrate containing portion 82 only by inserting the control circuit substrate 12c in the wiring substrate containing portion 82 without use of any jig after coating the ground of the wiring substrate containing portion 82 with the adhesive 15.

### (Embodiment 5)

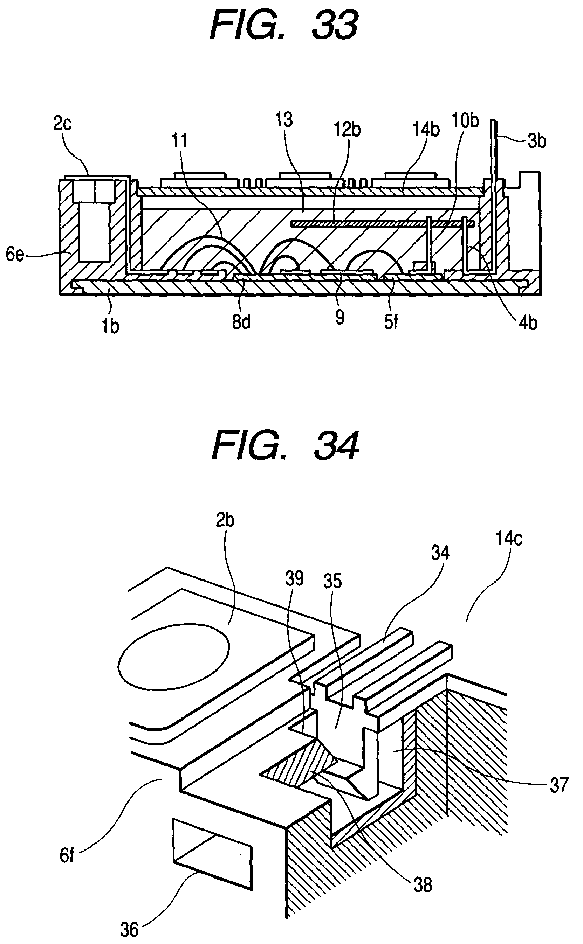

Fig. 32 is a plan view showing a further embodiment of the IPM, and Fig. 33 is a sectional view of the IPM. In Embodiment 1, there is shown an arrangement of the ceramic substrate containing portion surrounded with a resin portion specialized for containing the ceramic substrates and the wiring substrate containing portion surrounded with a resin portion specialized for containing the wiring substrate, wherein the wiring planes of the main terminals are provided on both sides of the ceramic substrate containing portion. In this embodiment, main terminals 2c positioned on an upper portion in Fig. 32 vertically pass through a side wall of a base-integral type case 6e so that wiring planes of the main terminals 2c are disposed on one side of the module. These wiring planes of the main terminals 2c are molded with a resin integrally with a metal base 1b and control terminals 3b. Such a configuration is effective to avoid interference between the inner wall of the case corner 55 and the wire bonding tool 56 shown in Embodiment 1.

Further, in this embodiment, there is shown a configuration example of a substrate containing portion 86 in which the ceramic substrate containing portion is integrated with the wiring substrate containing portion and one resin frame is formed. External input/output control terminals 3b and 4b of the module, connection control terminals 10b, and the metal base 1b are the same as those in Embodiment 1. A wiring substrate 5f for mounting the connection terminals 10b is formed with a projection 88 used for positioning between ceramic substrates 8c and 8e in co-operation of a projection 87 provided on a resin frame 86. Further, the wiring substrate 5f is provided with projections 89 used for positioning the ceramic substrates 8c and 8e with respect to the wiring substrate 5f in self-alignment, and for providing a gap 100 between the ceramic substrates 8c and 8e and the wiring substrate 5f so as to promote permeation of the silicon gel 13 thereby avoiding occurrence of gel voids.

In this embodiment, there are shown the projections 89 provided on the wiring substrate 5f for positioning the ceramic substrates 8c and 8d with respect to the wiring substrate 5f in self-alignment; however, like Embodiment 2, projections may be formed on the resin frame 86 for positioning the ceramic substrates 8c and 8e with respect to the wiring substrate 5f in self-alignment. Further, the step 91 shown in Embodiment 1 may be provided on each of the wiring substrate 5f and the resin frame 86 for positioning between the ceramic substrates 8c and 8d. In addition, the shape and the number of the projections are not limited to those shown in Fig. 32. Additionally, the projections 89 may be provided on the outer periphery of the wiring substrate 5f or on the outer peripheries of the ceramic substrates 8c and 8d. In this way, a positioning means for positioning the substrates with respect to the case using the resin frame 86 and the projections 89, and the configuration of the projections for providing a gap 95 and the gap 100 between the resin frame 86 and each substrate are not limited to those shown in Fig. 32.

In this embodiment, the wiring substrate 5f is formed into an elongated shape, specifically, an approximately trapezoidal shape; however, it may be formed into an L-shape surrounding one side of the ceramic substrates 8c and 8d; a turned sqaure U-shape surrounding two sides of the ceramic substrates; an approximately T-shape with the projection 88 inserted between the ceramic substrates; or an approximately square hole shape for containing the ceramic substrates 8c and 8d, which is further provided with projections 88 and 89. In addition, a positioning means for positioning the ceramic substrates 8c and 8d with respect to the wiring substrate 5f in self-alignment and the shape of the wiring substrate 5f are not limited to those shown in Fig. 32.

The structure shown in Fig. 32 is assembled, like Embodiment 1, by positioning the ceramic substrates 8c and 8d and the wiring substrate 5f with respect to the case 6e in self-alignment on the basis of the projections 92 provided on the resin frame 86 and the projections 87 and 88, and positioning the power semiconductor devices 9 with respect to the case 6e using the same jig (not shown) as the jig 64 shown in Embodiment 1. In addition, this embodiment can be applied to the PM shown in Embodiment 3 and to the IPM or PM shown in Embodiment 4 in which the ceramic substrates and the wiring circuit substrate for mounting the control circuit are disposed on the metal base.

### (Embodiment 6)

Fig. 34 is a detailed sectional view in perspective of a lid's outer claw mounting structure. In Embodiment 1, the lid has a fitting structure using the right and left inner claws. In this embodiment, an outer claw 35 is provided on one side of a lid 14c, and a square hole 36 not penetrating inside a case 6f is formed in a side surface of the case 6f and a square hole 37 having a slope 39 as an insertion guide for containing the outer claw 35 of the lid is formed in an upper surface of the case in such a manner as to be communicated to the square hole 36, to form an inner claw 38. This fitting structure is of a key type in which once the lid 14c is fitted with the case 6f, the mounting of the lid 14c is perfectly locked by means of the outer claw 35 provided on one side of the lid 14c. The outer claw 35 is not required to be provided with the square hole 33 for release upon rein-molding shown in Embodiment 1, and consequently, even if the gap between the main terminals 2b is further narrowed, it is possible to prevent breakage of the claw in combination with the ribs 34. In addition, the square hole 36 provided in the case 6f to be fitted in the outer claw 35 may be replaced with a round hole, and also the outer claws may be provided on both sides, that is, on the right and left sides of the lid 14c.

The structure of the power semiconductor module and fabrication method thereof according to the present invention described above are advantageous in reducing the conventional soldering works to one half and improving the reliability of portions joined by soldering and portions wired using metal wires by wire bonding; and further avoiding occurrence of gel voids, and significantly improving the reliability and workability in assembly by a positioning means allowing easy and high accurate positioning of substrates in self-alignment and its structure, thereby realizing a high reliability module at a low cost.

## Claims

1. A power semiconductor module comprising:
a metal base;
plural wiring substrates provided on said metal base, a first wiring substrate of the wiring substrates having a power circuit including a power semiconductor device;
a substrate containing portions having a resin portion in which one of said wiring substrstes is contained, and
wherein said one of said wiring substrates is positioned in self-alignment on said metal substrate on the basis of an inner wall of said resin portion of the substrate containing portion.

2. A power semiconductor module according to claim 1, wherein a second wiring substrate of the wiring substrates has a control circuit for controlling the power circuit.

3. A power semiconductor module according to claim 2, wherein a third wiring substrate of the wiring substrates has terminals for electrically connecting the power circuit to the control circuit.

4. A power semiconductor module according to claim 3, wherein the third wiring substrate is arraged on one side of the module.

5. A power semiconductor module according to claim 1, wherein a minimum value of a gap between at least two sides of said one of the wiring substrates and said resin portion of the substrate containing portion is in a range of 1.1 mm or less.

6. A power semiconductor module according to claim 1, wherein the resin portion of the substrate containing portion is formed with a step for allowing the wiring substrates to be contained in the substrate containing portion in such a manner as to be deviated from each other, and the step is used for positioning between the wiring substrates.

7. A power semiconductor module according to claim 1, wherein the resin porton of the substrate containing portion has a projection for positioning said one of the wiring substrates.

8. A power semiconductor module according to claim 1, wherein said one of the substrates has a projection for positioning said one of the substrates.

9. A power semiconductor module according to claim 3, wherein the terminals are arranged in a line with a specific pitch and are fixed with a resin to form connection terminals.

10. A power semiconductor module according to claim 1, further comprising an input/output control terminal of the module, wherein a second wiring substrate of the wiring substrates has a bonding pad for a connection between said one of th wiring substrates and said input/output control terminal.

11. A power semiconductor module according to claim 2, further comprising an input/output control terminal of the module, wherein the second wiring substrate has bonding pads for both of a connection between the powercircuit and the control circuit and a connection between the control circuit and the input/output control terminal.

12. A power semiconductor module according to claim 2, further comprising a resin layer integrated with the resin portion provided on the ground of the wiring substrate containing portion, wherein the second wiring substrate is electrically insulated to the metal base by the resin layer.
